# EUROPÄISCHE PATENTSCHRIFT

(11) **EP 2 460 194 B1**
(45) Veröffentlichungstag und Bekanntmachung des Hinweises auf die Patenterteilung: **21.02.2018**
(21) Anmeldenummer: 10736704.7
(22) Anmeldetag: 23.07.2010
(51) Int. Cl.: H01L 35/08, H01L 35/34

(54) **VERFAHREN ZUM AUFBRINGEN VON SCHICHTEN AUF THERMOELEKTRISCHE MATERIALIEN**
METHOD FOR DEPOSITING LAYERS ONTO THERMOELECTRIC MATERIALS
PROCÉDÉ POUR APPLIQUER DES COUCHES SUR DES MATÉRIAUX THERMOÉLECTRIQUES

(30) Priorität: 27.07.2009 EP 09166445
(43) Veröffentlichungstag der Anmeldung: 06.06.2012
(73) Patentinhaber: BASF SE, 67056 Ludwigshafen am Rhein (DE)
(72) Erfinder: HAASS, Frank, 64390 Erzhausen (DE); STEFAN, Madalina Andreea, 67063 Ludwigshafen (DE); DEGEN, Georg, 64653 Lorsch (DE)
(86) Internationale Anmeldenummer: PCT/EP2010/060696
(87) Internationale Veröffentlichungsnummer: WO 2011/012544

(56) Entgegenhaltungen:
- WO-A2-2008/061823
- US-A- 3 261 079
- US-A- 3 650 844

## Beschreibung

Die Erfindung betrifft Verfahren zum Aufbringen mindestens einer Schicht, ausgewählt aus Diffusionsbarrieren, weiteren Schutzschichten, Haftvermittlern, Loten und Kontakten, auf thermoelektrische Materialien.
Thermoelektrische Generatoren und Peltier-Anordnungen als solche sind seit langem bekannt. p- und n-dotierte Halbleiter, die auf einer Seite erhitzt und auf der anderen Seite gekühlt werden, transportieren elektrische Ladungen durch einen äußeren Stromkreis, wobei an einem Verbraucher im Stromkreis elektrische Arbeit verrichtet werden kann. Der dabei erzielte Wirkungsgrad der Konversion von Wärme in elektrische Energie wird thermodynamisch durch den Carnot-Wirkungsgrad limitiert. Somit wäre bei einer Temperatur von 1000 K auf der heißen und 400 K auf der "kalten" Seite ein Wirkungsgrad von (1000 - 400) : 1000 = 60 % möglich. Bis heute werden jedoch nur Wirkungsgrade bis 6 % erzielt.
Legt man andererseits einen Gleichstrom an eine derartige Anordnung an, so wird Wärme von einer Seite zur anderen Seite transportiert. Eine derartige Peltier-Anordnung arbeitet als Wärmepumpe und eignet sich deshalb zur Kühlung von Apparateteilen, Fahrzeugen oder Gebäuden. Auch die Heizung über das Peltier-Prinzip ist günstiger als eine herkömmliche Heizung, weil immer mehr Wärme transportiert wird als dem zugeführten Energieäquivalent entspricht.

Einen guten Überblick über Effekte und Materialien gibt z. B. S. Nolas et al., Recent Developments in Bulk Thermoelectric Materials, MRS Bulletin, Vol. 31, 2006, 199-206.
Gegenwärtig werden thermoelektrische Generatoren in Raumsonden zur Erzeugung von Gleichströmen, für den kathodischen Korrosionsschutz von Pipelines, zur Energieversorgung von Leucht- und Funkbojen, zum Betrieb von Radios und Fernsehapparaten eingesetzt. Die Vorteile der thermoelektrischen Generatoren liegen in ihrer äußersten Zuverlässigkeit. So arbeiten sie unabhängig von atmosphärischen Bedingungen wie Luftfeuchte; es erfolgt kein störungsanfälliger Stofftransport, sondern nur ein Ladungstransport; der Betriebsstoff wird kontinuierlich - auch katalytisch ohne freie Flamme - verbrannt, wodurch nur geringe Mengen an CO, NOₓ und unverbranntem Betriebsstoff frei werden; es sind beliebige Betriebsstoffe einsetzbar von Wasserstoff über Erdgas, Benzin, Kerosin, Dieselkraftstoff bis zu biologisch erzeugten Kraftstoffen wie Rapsölmethylester.

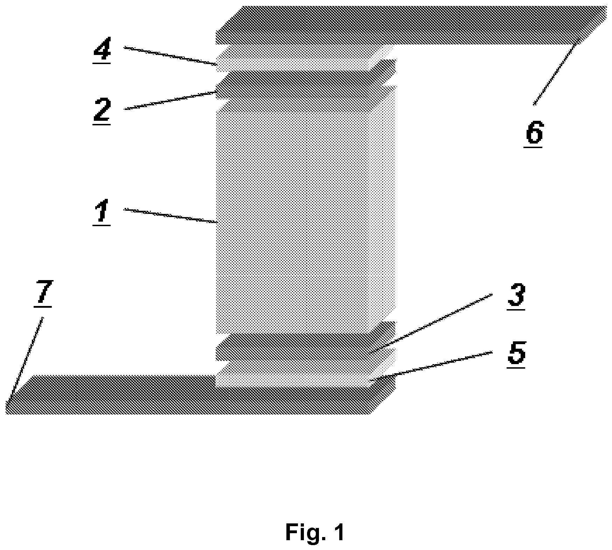

Damit passt sich die thermoelektrische Energiewandlung äußerst flexibel in künftige Bedürfnisse wie Wasserstoffwirtschaft oder Energieerzeugung aus regenerativen Energien ein.
Ein wesentliches Element thermoelektrischer Bauteile ist die elektrische Kontaktierung. Dokument US3261079 offenbart ein Verfahren bei dem zu Kontaktierung Folien auf ein thermoelektrisches Material aufgepresst und mittels eines Lotes dort befestigt werden. Die Kontaktierung stellt die physikalische Verbindung zwischen dem Material im "Herzen" des Bauteils (das für den gewünschten thermoelektrischen Effekt des Bauteils verantwortlich ist) und der "Außenwelt" her. Im Detail ist der Aufbau eines solchen Kontaktes in Fig. 1 schematisch dargestellt.

Das thermoelektrische Material **1** innerhalb des Bauteils sorgt für den eigentlichen Effekt des Bauteils. Dies ist ein thermoelektrischer Schenkel. Das Material **1** ist von einem Wärmestrom durchflossen, was die Elektronenbewegung und damit einen elektrischen Stromfluss erzeugt, um seinen Zweck in dem Gesamtaufbau zu erfüllen.

Das Material **1** ist an zumindest zwei Seiten über die Kontakte **4** und **5** mit den Zuleitungen **6** bzw. **7** verbunden. Die Schichten **2** und **3** sollen dabei eine oder mehrere gegebenenfalls notwendige Zwischenschichten (Barrierematerial, Lot, Haftvermittler o.ä.) zwischen dem Material **1** und den Kontakten **4** und **5** symbolisieren. Die jeweils paarweise zueinander gehörenden Segmente **2/3, 4/5, 6/7** können, müssen aber nicht identisch sein. Dies hängt letztlich ebenfalls vom spezifischen Aufbau und der Anwendung ab, ebenso wie auch die Flussrichtung von elektrischem Strom bzw. Wärmestrom durch den Aufbau.
Eine wichtige Rolle kommt nun den Kontakten **4** und **5** zu. Diese besorgen eine enge Verbindung zwischen Material und Zuleitung. Sind die Kontakte schlecht, so treten hier hohe Verluste auf, die die Leistung des Bauteils stark einschränken können. Aus diesem Grund werden die Kontakte häufig auch auf das Material aufgepresst. Die Kontakte sind also einer starken mechanischen Belastung ausgesetzt. Diese mechanische Belastung nimmt noch zu, sobald erhöhte (oder auch erniedrigte) Temperaturen oder/und thermische Wechsel eine Rolle spielen. Die thermische Ausdehnung der im Bauteil verbauten Materialien führt unweigerlich zu mechanischer Spannung, die im Extremfall durch einen Abriss des Kontaktes zu einem Versagen des Bauteils führen.
Um dem vorzubeugen, müssen die verwendeten Kontakte eine gewisse Flexibilität und Federeigenschaften aufweisen, damit solche thermischen Spannungen ausgeglichen werden können.
Thermoelektrische Materialien müssen, um sie in Module oder Bauteile integrieren zu können, mit einer Reihe von Schichten versehen werden. Dies sind zunächst Diffusionsbarrieren, die eine sukzessive Verunreinigung des thermoelektrischen Materials durch Ionenwanderung aus höher liegenden Schichten verhindern. Weitere Schutzschichten, Lotschichten und Kontaktvermittler folgen, bis schließlich durch eine Metallbrücke der elektrische Kontakt zum benachbarten Schenkel innerhalb des Moduls hergestellt wird.
Normalerweise werden diese Schichten Schritt für Schritt aufgebracht. Konventionelle Technologien sind Bedampfen und Besputtern, das Aufbringen flüssiger Lote usw.
Dabei kommt sowohl eine Beschichtung und Kontaktierung einzelner Schenkel in Betracht, als auch die Applikation auf einer größeren Materialscheibe, die nachträglich zu einzelnen Schenkeln klein geschnitten wird. Diese Schenkel können dann zum Beispiel miteinander verlötet werden.
Nachteilig sind der hohe Zeit- und Kostenaufwand durch das sukzessive Aufbringen der Schichten sowie durch die Behandlung einzelner Schenkel.
Aufgabe der vorliegenden Erfindung ist die Bereitstellung eines Verfahrens zum Aufbringen derartiger Schichten auf thermoelektrische Materialien, das in unaufwendiger Weise, vorzugsweise kontinuierlich, durchgeführt werden kann und die Nachteile der bestehenden Verfahren vermeidet.

Die Aufgabe wird erfindungsgemäß gelöst durch das Verfahren nach Anspruch 1. Weitere vorteilhafte Ausführungsformen ergeben sich aus den Unteransprüchen. Das thermoelektrische Material kann beim Aufbringen der Schichten verformt werden.
Das thermoelektrische Material wird dabei soweit erweicht, dass es plastisch verformt und unter Druck mit der mindestens einen Schicht verbunden werden kann. In diesem Sinne sind die Begriffe "duktil" und "fließfähig" zu verstehen.

Das erfindungsgemäße Verfahren erlaubt es, in einem kontinuierlichen Prozess beschichtete Materialien herzustellen, die nach einem einfachen Schneidprozess direkt in thermoelektrische Module verbaut werden können. Erfindungsgemäß wird die mindestens eine Schicht vor dem Aufwalzen oder Aufpressen in Form einer Folie oder eines Folienstapels auf das thermoelektrische Material aufgelegt.
Die dahinter stehende Idee besteht darin, das thermoelektrische Material mit den notwendigen Beschichtungen in Form von Folien zu belegen und die Lagen mit dem thermoelektrischen Material unter Druck und gegebenenfalls Temperaturbehandlung in einem Arbeitsgang zu einem "Sandwich" zu verdichten. Dabei sollte die Verdichtung bei einer Temperatur erfolgen, bei der das thermoelektrische Material duktil oder fließfähig ist. Dies kann notwendig sein, damit das normalerweise mehr oder weniger spröde Halbleitermaterial nicht bricht.
Die geeignete Temperatur wird abhängig vom jeweiligen thermoelektrischen Material gewählt. Vorzugsweise liegt die Temperatur für PbTe in einem Bereich von 400 bis 900 °C, besonders bevorzugt 500 bis 750 °C.

Die beim Aufpressen oder Aufwalzen anzulegenden Drücke sind so zu bemessen, dass die aufzubringenden Schichten fest haftend mit dem thermoelektrischen Material verbunden werden. Es werden die typischerweise beim Aufpressen oder Aufwalzen herrschenden Drücke eingestellt. Vorzugsweise liegt der Druck im Bereich von 0 bis 100 MPa, besonders bevorzugt im Bereich von 1 bis 30 MPa. Erfindungsgemäß werden die Funktionsbarriere, gegebenenfalls weitere Schutzschichten, Haftvermittler, Lote und/oder elektrische Kontakte in einem Arbeitsgang gleichzeitig auf das thermoelektrische Material aufgebracht. Hierzu ist es besonders vorteilhaft, wenn entsprechend dünne Folien aus den jeweiligen Schichtmaterialien vorliegen. Die Dicke der jeweiligen Schichten kann entsprechend der Anforderungen angepasst werden. Vorzugsweise beträgt die Schichtdicke im fertigen thermoelektrischen Materialsandwich für Schutzschichten und elektrische Kontakte 100 µm bis 5 mm.
Die erfindungsgemäß bevorzugt eingesetzten Folien weisen eine demgegenüber größere Schichtdicke auf, so dass es beim Verpressen oder Aufwalzen zu einer Längenänderung der Folie kommen kann.
Die Schutzschichten und elektrischen Kontakte sind Metalle, Semimetalle, Halbleiter, Graphite, Graphen oder bestehen aus mindestens einem chemischen Element der thermoelektrischen Materialien.
Das erfindungsgemäße Verfahren kann kontinuierlich oder diskontinuierlich durchgeführt werden. Ein Aufpressen erfolgt normalerweise diskontinuierlich. Demgegenüber bevorzugt ist ein Aufwalzen, dass kontinuierlich an einem Band des thermoelektrischen Materials durchgeführt werden kann.

Für das Aufwalzen sind unterschiedliche Walzprozesse denkbar. Im einfachsten Fall werden durch eine Walze mehrere Lagen verdichtet und dabei die Schichten mit dem Material verbunden. Es können auch mehrere Walzen gleichzeitig oder hintereinander eingesetzt werden.

Gemäß einer Ausführungsform der Erfindung kann nach dem Aufwalzen oder Aufpressen eine Temperung des thermoelektrischen Materialsandwiches drucklos oder unter Druck erfolgen. Die Temperung kann zum Ausgleich gegebenenfalls vorliegender mechanischer Spannungen im Bauteil dienen. Eine Temperung unter Druck ist möglich, aber nicht unbedingt nötig.

Die oberste Schicht kann direkt der metallische Kontakt sein, über den die Schenkel im endgültigen Aufbau in Reihe elektrisch kontaktiert sind. Die Natur und die Anzahl der Schichten hängen von den jeweiligen Anforderungen im weiteren Modulbauprozess sowie vom thermoelektrischen Material ab und unterliegen keiner Einschränkung. Vorzugsweise werden mit dem erfindungsgemäßen Verfahren eine oder mehrere Schichten, insbesondere 1 bis 5 Schichten, aufgebracht.

Erfindungsgemäß können nach dem Aufwalzen oder Aufpressen und gegebenenfalls Tempern aus dem so erhaltenen thermoelektrischen Materialsandwich einzelne Schenkel ausgesägt oder ausgeschnitten werden, die sodann im thermoelektrischen Modulbau eingesetzt werden können. Das Aussägen oder Ausschneiden kann mittels üblicher bekannter Verfahren durchgeführt werden. Beispiele sind konventionelle Sägen, Laserschneiden, Wasserstrahlschneiden usw. Neben der einfachen und vor allem kontinuierlichen Durchführung des Verfahrens liegt ein weiterer Vorteil des Verfahrens in der erreichten Planparallelität der Schenkel sowie der exakt einstellbaren Schenkelhöhe. Für einen Einbau in ein thermoelektrisches Modul ist es aus geometrischen Gründen besonders vorteilhaft, dass alle Schenkel die gleiche Höhe sowie planparallele Stirnflächen haben. Hierdurch ist eine effiziente Kontaktierung mit einem Substrat möglich.

Im erfindungsgemäßen Verfahren kann das thermoelektrische Material nebeneinander p- und n-leitende thermoelektrische Materialien in einer solchen Geometrie enthalten, die das nachfolgende Zersägen oder Zerschneiden in einzelne Schenkel des thermoelektrischen Materials erlaubt, welche sodann im thermoelektrischen Modulbau eingesetzt werden können. Damit können auch p- und n-Materialreihen in einem Arbeitsgang verpresst und später durch Sägen wieder in die einzelnen fertig beschnittenen und konfektionierten Schenkel getrennt werden. Auch hier ist die hohe geometrische Güte der p- und n-Schenkel von Vorteil, die sich günstig auf den Einbau im thermoelektrischen Modul auswirkt.

Erfindungsgemäß können die thermoelektrischen Materialien zugleich p- und n-Ieitende thermoelektrische Materialien enthalten, deren Vermischung über senkrecht zur Schichtfolge zwischen den p- und n-Ieitenden thermoelektrischen Materialien eingebrachte Spacer verhindert werden. Der Spacer sollte demnach senkrecht zum Schichtaufbau eingebracht werden. Er soll ein Vermischen bzw. Ineinanderfließen oder Diffundieren von p- und n-Materialien verhindern.

Der Spacer ist bevorzugt ein elektrisch isolierendes Material, das vorzugsweise Keramik, Glas, Glimmer, organische oder natürliche Polymere enthält. Seine Dicke beträgt bevorzugt 0,1 mm bis 5 cm.

Der Spacer kann dabei nach dem Aufwalzen oder Aufpressen durch Heraussägen, Herausschneiden, Herausbrennen, Zersetzen oder Herauslösen mit einem Lösungsmittel aus dem thermoelektrischen Materialsandwich entfernt werden.

Weiterhin kann der Spacer gezielt als Separator zwischen den p- und n-Schenkeln eines Moduls eingesetzt werden. Hierdurch kann während des Kontaktierungs- bzw. Walzprozesses nicht nur eine Sandwichplatte für die Schenkelfertigung hergestellt werden, sondern direkt ein thermoelektrischer Modulgrundkörper aus alternierenden p- und n-Schenkeln. Dies setzt allerdings voraus, dass die oberste bzw. unterste Schicht, das Substrat, keine einfache Metallplatte ist, sondern eine Strukturierung besitzt, die jeweils p- und n-Schenkel miteinander elektrisch leitend verbindet, aber dazwischen elektrisch isoliert. Dies entspricht dem klassischen Modulaufbau. Entsprechend können die auf die thermoelektrischen Materialien oberflächlich aufgebrachten Kontaktfolien so strukturiert sein, dass sich auf den thermoelektrischen Materialsandwiches leitfähige und nicht leitfähige Bereiche ergeben, wobei der gesamte Aufbau dem Design eines thermoelektrischen Moduls entspricht.

Weiterhin kann der Spacer eine Matrix für das thermoelektrische Modul sein, wo Pulver, Schmelze oder fertige thermoelektrische Schenkel, Barren oder Platten eingefüllt werden und anschließend die Schutzschichten und Kontakte aufgewalzt oder aufgepresst werden können.

Der Spacer kann ein organisches Polymer oder ein elektrisch isoliertes Material wie Glas, Glimmer, Keramik oder Kombination davon sein.

Das thermoelektrische Material an sich kann auf beliebigen geeigneten thermoelektrischen Materialien basieren. Bevorzugt basiert das thermoelektrische Material auf Bleitelluriden.

Die Halbleitermaterialen können nach Methoden zu thermoelektrischen Generatoren oder Peltier-Anordnungen zusammengefügt werden, welche an sich bekannt sind und beispielsweise beschrieben in WO 98/44562, US 5,448,109, EP-A-1 102 334 oder US 5,439,528.

Die Erfindung betrifft auch die Verwendung von Walzen zum Aufbringen von mindestens einer Schicht, ausgewählt aus Diffusionsbarrieren, weiteren Schutzschichten, Haftvermittlern, Loten und Kontakten, auf thermoelektrische Materialien.

Die erfindungsgemäß hergestellten thermoelektrischen Generatoren oder Peltier-Anordnungen werden bevorzugt eingesetzt als Wärmepumpe, zur Klimatisierung von Sitzmöbeln, Fahrzeugen und Gebäuden, in Kühlschränken und (Wäsche)Trocknern, zur simultanen Heizung und Kühlung von Stoffströmen bei Verfahren der Stofftrennung wie Absorption, Trocknung, Kristallisation, Verdampfung oder Destillation, als Generator zur Nutzung von Wärmequellen wie solarer Energie, Erdwärme, Verbrennungswärme fossiler Brennstoffe, von Abwärmequellen in Fahrzeugen und stationären Anlagen, von Wärmesenken beim Verdampfen flüssiger Stoffe oder biologischer Wärmequellen, oder zur Kühlung elektronischer Bauteile.

## Patentansprüche

1. Verfahren zum Aufbringen von Diffusionsbarrieren, Haftvermittlern, Loten und elektrischen Kontakten und gegebenenfalls weiteren Schutzschichten (3-6) auf thermoelektrische Materialien (1), **dadurch gekennzeichnet, dass** die Diffusionsbarriere, Haftvermittler, Lote und elektrische Kontakte und gegebenenfalls weitere Schutzschichten in einem Arbeitsgang gleichzeitig auf das thermoelektrische Material bei einer Temperatur, bei der das thermoelektrische Material duktil und soweit erweicht ist, dass es plastisch verformt werden kann, aufgewalzt oder aufgepresst werden, wobei dünne Folien aus den jeweiligen Schichtmaterialien vor dem Aufwalzen oder Aufpressen auf das thermoelektrische Material aufgelegt und unter Druck mit diesem verbunden werden.

2. Verfahren nach Anspruch 1, **dadurch gekennzeichnet, dass** nach dem Aufwalzen oder Aufpressen eine Temperung des so erhaltenen thermoelektrischen Materialsandwichs drucklos oder unter Druck erfolgt.

3. Verfahren nach einem der Ansprüche 1 oder 2, **dadurch gekennzeichnet, dass** nach dem Aufwalzen oder Aufpressen und gegebenenfalls Tempern aus dem so erhaltenen thermoelektrischen Materialsandwich einzelne Scheiben ausgesägt oder ausgeschnitten werden, die sodann im thermoelektrischen Modulbau eingesetzt werden können.

4. Verfahren nach einem der Ansprüche 1 bis 3, **dadurch gekennzeichnet, dass** das thermoelektrische Material zugleich p- und thermoelektrische Materialien in einer solchen Geometrie enthält, die das nachfolgende Zersägen oder Zerschneiden in einzelne Schenkel des thermoelektrischen Materials erlaubt, welche sodann im thermoelektrischen Modulbau eingesetzt werden können.

5. Verfahren nach einem der Ansprüche 1 bis 4, **dadurch gekennzeichnet, dass** das thermoelektrische Material zugleich p- und Materialien enthält, deren Vermischung über senkrecht zur Schichtenfolge zwischen den p- und n- leitenden thermoelektrischen Materialien eingebrachte Spacer verhindert wird.

6. Verfahren nach Anspruch 5, **dadurch gekennzeichnet, dass** der Spacer ein elektrisch isolierendes Material ist.

7. Verfahren nach Anspruch 6, **dadurch gekennzeichnet, dass** der Spacer Keramik, Glas, Glimmer, organische oder natürliche Polymere enthält.

8. Verfahren nach einem der Ansprüche 5 bis 7, **dadurch gekennzeichnet, dass** der Spacer eine Dicke von 0,1 mm bis 5 cm aufweist.

9. Verfahren nach einem der Ansprüche 5 bis 8, **dadurch gekennzeichnet, dass** der Spacer nach dem Aufwalzen oder Aufpressen durch Heraussägen, Herausschneiden, Herausbrennen, Zersetzen oder Herauslösen mit einem Lösungsmittel aus dem thermoelektrischen Materialsandwich entfernt wird.

10. Verfahren nach einem der Ansprüche 1 bis 9, **dadurch gekennzeichnet, dass** auf die thermoelektrischen Materialien oberflächlich aufgebrachte Kontaktfolien so strukturiert sind, dass sich auf den thermoelektrischen Materialsandwiches leitfähige und nicht leitfähige Bereiche ergeben, wobei der gesamte Aufbau dem Design eines thermoelektrischen Moduls entspricht.

11. Verfahren nach einem der Ansprüche 1 bis 10, **dadurch gekennzeichnet, dass** das thermoelektrische Material auf Bleitelluriden basiert.

## Claims

1. A method for applying diffusion barriers, adhesion promoters, solders and electrical contacts and optionally further protective layers (3-6) onto thermoelectric materials (1), wherein the diffusion barrier, adhesion promoters, solders and electrical contacts and optionally further protective layers are rolled or pressed simultaneously onto the thermoelectric material in one work process at a temperature at which the thermoelectric material is ductile and softened to the extent that it can be plastically deformed, where thin films of the respective layer materials are placed onto the thermoelectric material prior to rolling or pressing and are connected thereto under pressure.

2. The method according to claim 1, wherein, after rolling or pressing, a heat treatment of the thermoelectric material sandwich thus obtained is effected without pressure or under pressure.

3. The method according to either of claims 1 and 2, wherein, after rolling or pressing and optionally heat treatment, individual slices are sawn or cut from the thermoelectric material sandwich thus obtained, which slices can then be used in the thermoelectric module construction.

4. The method according to any of claims 1 to 3, wherein the thermoelectric material simultaneously contains p- and n- conducting thermoelectric materials in such a geometry that permits subsequent sawing or cutting into individual legs of the thermoelectric material, which legs can then be used in the thermoelectric module construction.

5. The method according to any of claims 1 to 4, wherein the thermoelectric material simultaneously contains p- and n- conducting materials, the mixing of which is prevented by means of spacers introduced perpendicularly to the layer sequence between the p- and n- conducting thermoelectric materials.

6. The method according to claim 5, wherein the spacer is an electrically insulating material.

7. The method according to claim 6, wherein the spacer contains ceramic, glass, mica, organic or natural polymers.

8. The method according to any of claims 5 to 7, wherein the spacer has a thickness of 0.1 mm to 5 cm.

9. The method according to any of claims 5 to 8, wherein the spacer is removed after rolling or pressing by being sawn, cut, burned or decomposed from the thermoelectric material sandwich or by being dissolved therefrom by means of a solvent.

10. The method according to any of claims 1 to 9, wherein contact films applied superficially onto the thermoelectric materials are structured in such a way that conductive and non-conductive regions are produced on the thermoelectric material sandwiches, the entire construction corresponding to the design of a thermoelectric module.

11. The method according to any of claims 1 to 10, wherein the thermoelectric material is based on lead tellurides.

## Revendications

1. Procédé d'application de barrières de diffusion, de promoteurs d'adhérence, de métaux d'apport de brasage et de contacts électriques et éventuellement d'autres couches de protection (3-6) sur des matériaux (1) thermoélectriques, **caractérisé en ce que** la barrière de diffusion, les promoteurs d'adhérence, les métaux d'apport de brasage et les contacts électriques et éventuellement d'autres couches de protection sont appliqués au rouleau ou par pression en une phase de travail simultanément sur le matériau thermoélectrique à une température à laquelle le matériau thermoélectrique est ductile ou est ramolli au point qu'il peut être déformé plastiquement, de minces feuilles des matériaux en couche respectifs étant, avant l'application au rouleau ou par pression, placées sur le matériau thermoélectrique et raccordées à celui-ci sous pression.

2. Procédé selon la revendication 1, **caractérisé en ce que**, après l'application au rouleau ou par pression, un recuit du sandwich de matériau thermoélectrique ainsi obtenu est effectué sans pression ou sous pression.

3. Procédé selon l'une des revendications 1 et 2, **caractérisé en ce que**, après l'application au rouleau ou par pression et éventuellement après le recuit, différentes tranches sont sciées ou découpées à partir du sandwich de matériau thermoélectrique ainsi obtenu, lesquelles peuvent ensuite être insérées dans la construction modulaire thermoélectrique.

4. Procédé selon l'une des revendications 1 à 3, **caractérisé en ce que** le matériau thermoélectrique contient en même temps des matériaux thermoélectriques conducteurs de type p et n dotés d'une géométrie telle qu'elle permet le sciage ou le découpage ultérieur en branches individuelles du matériau thermoélectrique qui peuvent ensuite être insérées dans la construction modulaire thermoélectrique.

5. Procédé selon l'une des revendications 1 à 4, **caractérisé en ce que** le matériau thermoélectrique contient en même temps des matériaux thermoélectriques conducteurs de type p et n dont le mélange est empêché par le biais de pièces d'espacement introduites perpendiculairement à la succession de couches entre les matériaux thermoélectriques conducteurs de type p et n.

6. Procédé selon la revendication 5, **caractérisé en ce que** la pièce d'écartement est un matériau électriquement isolant.

7. Procédé selon la revendication 6, **caractérisé en ce que** la pièce d'écartement contient de la céramique, du verre, du mica, des polymères organiques ou naturels.

8. Procédé selon l'une des revendications 5 à 7, **caractérisé en ce que** la pièce d'écartement présente une épaisseur de 0,1 mm à 5 cm.

9. Procédé selon l'une des revendications 5 à 8, **caractérisé en ce que**, après l'application au rouleau ou par pression, la pièce d'écartement est enlevée du sandwich de matériau thermoélectrique par sciage, découpage, combustion, désintégration ou dissolution avec un solvant.

10. Procédé selon l'une des revendications 1 à 9, **caractérisé en ce que** des feuilles de contact appliquées superficiellement sur les matériaux thermoélectriques sont structurées de telle sorte que, sur les sandwiches de matériau thermoélectrique, il résulte des zones conductrices et non conductrices, la construction totale correspondant au design d'un module thermoélectrique.

11. Procédé selon l'une des revendications 1 à 10, **caractérisé en ce que** le matériau thermoélectrique est basé sur des tellurures de plomb.
